# EUROPEAN PATENT APPLICATION

(11) **EP 4 671 694 A1**
(43) Date of publication of application: **31.12.2025**
(21) Application number: 25157502.3
(22) Date of filing: 12.02.2025
(51) Int. Cl.: G01D 5/26, H02K 11/22, H02P 6/16, G06T 7/73

(54) **IMAGE-BASED POSITION SENSOR**

(30) Priority: 26.06.2024 US 202418754299
(71) Applicant: Allegro MicroSystems, LLC, Manchester, NH 03103 (US)
(72) Inventor: HAAS, David J., Concord, 03301 (US); ALIZAD, Sina Haji, Manchester, 03103 (US)
(74) Representative: South, Nicholas Geoffrey

(57) **Abstract**

A device, comprising: a position sensor including an optical sensing element and an image processor, the image processor being configured to use the optical sensing element to take images of a visual mark that is formed on a target, detect a position of the target based on the images, and generate a first signal that is indicative of the position of the target; a current sensor including one or more magnetic field sensing elements, the current sensor being configured to measure a level of electrical current through a conductor, and generate a second signal that is indicative of the level of the electrical current through the conductor; and a motor controller that is configured to receive the first and second signals and generate a third signal for powering an electric motor, the third signal being generated based on the first and second signals; and a semiconductor package.

## Description

### BACKGROUND

Position sensors are vital components in various technological applications, serving the crucial function of determining the spatial location or displacement of an object. These sensors play a pivotal role in fields such as robotics, automotive systems, aerospace, and industrial automation. The primary objective of position sensors is to provide accurate and real-time information about the position of an object relative to a reference point. There are diverse types of position sensors, including linear and rotary sensors, which employ various technologies such as resistive, inductive, capacitive, magnetic, or optical mechanisms to measure displacement. These sensors enable precise control and feedback in dynamic systems, ensuring the optimal functioning of machinery and enhancing overall efficiency.

### SUMMARY

According to aspects of the disclosure, a device is provided, comprising: a position sensor including an optical sensing element and an image processor, the image processor being configured to use the optical sensing element to take images of a visual mark that is formed on a target, detect a position of the target based on the images, and generate a first signal that is indicative of the position of the target; a current sensor including one or more magnetic field sensing elements, the current sensor being configured to measure a level of electrical current through a conductor, and generate a second signal that is indicative of the level of the electrical current through the conductor; a motor controller that is configured to receive the first and second signals and generate a third signal for powering an electric motor, the third signal being generated based on the first and second signals; and a semiconductor package that is configured to encapsulate the position sensor, the current sensor, and the motor controller, the semiconductor package including a light transmissive portion that is configured to pass through light originating from outside of the package to the optical sensing element.

According to aspects of the disclosure, a device is provided, comprising: a position sensor including an optical sensing element and an image processor, the image processor being configured to use the optical sensing element to take images of a visual mark that is formed on a target, detect a position of the target based on the images, and generate a first signal that is indicative of the position of the target; a light-emitting diode (LED) driver; and a semiconductor package that is configured to encapsulate the position sensor and the LED driver, the semiconductor package including a light transmissive portion that is configured to pass through light originating from outside of the package to the optical sensing element.

According to aspects of the disclosure, a sensing device, comprising: an image sensor that is configured to capture an image of a visual mark formed on a target; a processing circuitry that is operatively coupled to the image sensor, the processing circuitry being configured to receive the image, process the image to identify a position of the target, and generate an output signal that is indicative of the position of the target.

According to aspects of the disclosure, a method for use in a sensor including an imaging sensor that is operatively coupled to a processing circuitry, the method comprising: obtaining, by the processing circuitry, an image of a visual mark that is formed on a target, the image being captured by the imaging sensor; applying edge detection on the image to produce a first transformed image; applying a Hough transform on the first transformed image to produce a second transformed image that identifies one or more peaks that are present in the first transformed image; evaluating a theta function based on the second transformed image, the theta function being configured to map each of the one or more peaks to a corresponding position of the target; selecting one of the peaks as corresponding to the visual mark; and outputting a signal that is indicative of the position of the target that corresponds to the selected peak.

### BRIEF DESCRIPTION OF THE DRAWINGS

The foregoing features may be more fully understood from the following description of the drawings in which:
FIG. 1A is a diagram of an example of a system, according to aspects of the disclosure;
FIG. 1B is a diagram of an example of a target, according to aspects of the disclosure;
FIG. 1C is diagram showing examples of images of the target of FIG. 1B, according to aspects of the disclosure;
FIG. 2A is a diagram of an example of a sensor, according to aspects of the disclosure;
FIG. 2B is a flowchart of an example of a process, according to aspects of the disclosure;
FIG. 3 is a diagram of an example of an image processor, according to aspects of the disclosure;
FIG. 4 is a diagram of an example of an image processor, according to aspects of the disclosure;
FIG. 5 is a flowchart of an example of a process, according to aspects of the disclosure;
FIG. 6 is a diagram of an example of a semiconductor package, according to aspects of the disclosure;
FIG. 7 is a diagram of an example of a semiconductor package, according to aspects of the disclosure;
FIG. 8A is a diagram of an example of a system, according to aspects of the disclosure;
FIG. 8B is a diagram of an example of images that are captured by a sensor, according to aspects of the disclosure;
FIG. 9 is a diagram of an example of a semiconductor package, according to aspects of the disclosure;
FIG. 10A is a diagram of an example of a system, according to aspects of the disclosure; and
FIG. 10B is a diagram of an example of images that are captured by a sensor, according to aspects of the disclosure.

### DETAILED DESCRIPTION

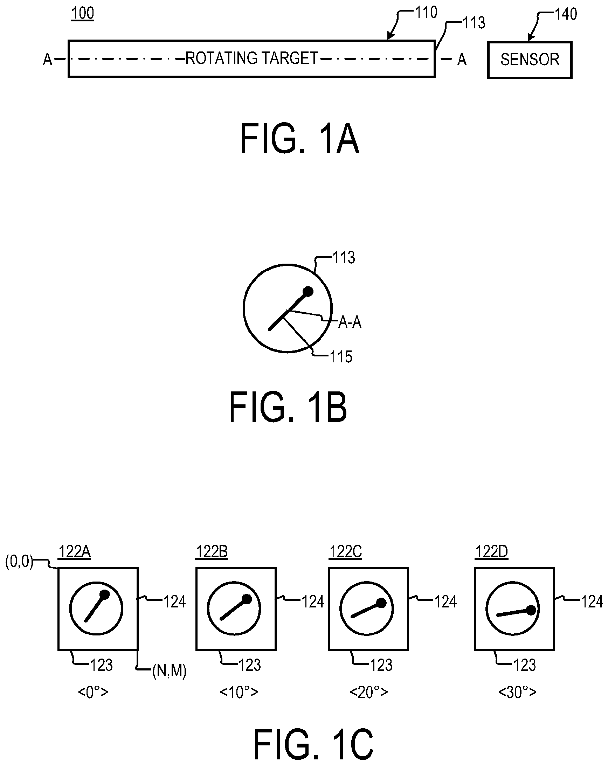

FIG. 1A is a diagram of an example of a system 100, according to aspects of the disclosure. As illustrated, system 100 may include a rotating target 110 and a sensor 140. According to the present example, target 110 is configured to rotate about an axis A-A. Sensor 140 is an image sensor that is configured to capture images of end 113 of target 110 and determine the position of target 110 based on those images. According to the present example, target 110 includes a shaft. However, the present disclosure is not limited to any specific implementation of target 110. For example, the target 110 may be a gear, a wheel and/or any other suitable mechanical element.

FIG. 1B shows an example of end 113 of target 110. As illustrated, the end 113 of target 110 may have a visual mark 115 formed thereon. The visual mark 115 may be etched, printed, glued, soldered, and/or painted on end 113. In some implementations, the visual mark 115 may be formed of plastic, metal, and or any other suitable material, and subsequently attached to target 110. As used throughout the disclosure, the term "a visual mark formed on a target" may refer to embodiments in which the visual mark is printed or etched on the target, as well as embodiments in which the visual mark is formed of metal or plastic, and subsequently glued (or otherwise attached) to target 110. In some implementations, the visual mark 115 may be invisible to the naked eye. For example, in some implementations, the visual mark 115 may be printed with invisible ink, which can be sensed by sensor 140 when illuminated with light outside of the visible spectrum. More particularly, visual mark 115 may be printed with ink that becomes detectable when the visual mark 115 is exposed to ultraviolet or infrared light.

FIG. 1C illustrates an example of images 122A-D of visual mark 115, which are captured by position sensor 140 for the purposes of identifying the position (*e*.*g*., angular position) of target 110. According to the present example, image 122A is captured when the position of target 110 is 0 degrees; image 122B is captured when the position of target 110 is 10 degrees; image 122C is captured when the position of target 110 is 20 degrees; and image 122D is captured when the position of target 110 is 30 degrees. Images 122A-D illustrate that, as target 110 rotates, the orientation and/or position of the visual mark 115 in the images captured by sensor 140 will change. In this regard, at any given instant, to determine the current position of target 110, sensor 140 may capture an image of end 113 of target 110. Next, position sensor 140 may use any suitable type of image recognition technique to determine the position of the visual mark 115 within the image and/or the orientation of the visual mark 115 relative to the edges of the image. Next, sensor 140 may map the position and/or orientation of the visual mark 115 in the image to an angular position of target 110. In some respects, using optical means to determine the angular position of a target is advantageous because it eliminates the need for a magnetic target, which would be required if a magnetic-based position sensor were to be used.

According to the example of FIGS. 1A-C, the visual mark 115 is a line having a dot at one end. However, the present disclosure is not limited to any specific implementation of the visual mark 115. For example, the visual mark 115 may consist of the dot only, or the mark may include a triangle or another geometric shape. In some implementations, the visual mark 115 may be asymmetrical. As used throughout the disclosure, the phrase "asymmetrical visual mark in a target" shall refer to any mark that is so arranged as to have a unique position and/or orientation within an image of the target at each of all possible positions of the target. In some implementations, the asymmetry may be with respect to the center of the surface of the target where that visual mark is formed

According to the example of FIG. 1B, visual mark 115 is an asymmetrical visual mark because it would appear as having a different orientation and/or position in the images of end 113 for each possible angular position of target 110. By contrast, a symmetrical mark may appear the same in images of a target that correspond to two different positions of the target. Although, in the example of FIGS. 1A-C, visual mark 115 is an asymmetrical mark, alternative implementations are possible in which visual mark 115 is a symmetrical mark. Stated succinctly, the present disclosure is not limited to any specific implementation of target 110 and/or visual mark 115.

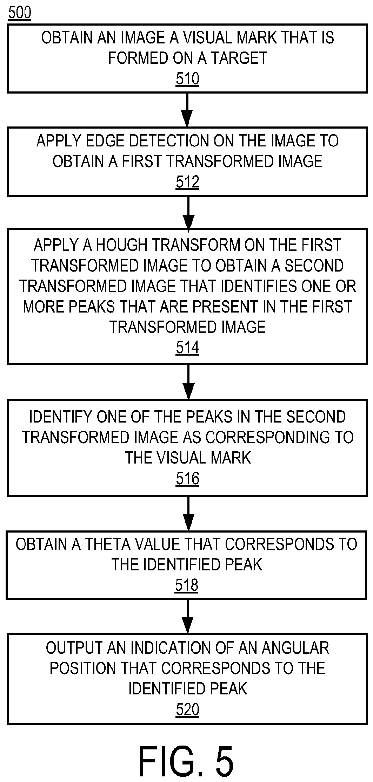

In some implementations, the position of visual mark 115 may be identified in the manner discussed further below with respect to FIG. 5. In some implementations, detecting the position of visual mark 115 within an image of end 113 may include identifying the coordinates of one or more pixels that depict the visual mark 115 within the image. Additionally or alternatively, detecting the position of visual mark 115 within an image may include identifying the coordinates of a cluster of pixels that at least partially represents the target. The pixel or cluster coordinates may be coordinates within the framework of the image. As illustrated with respect to image 122A (shown in FIG. 1C), in an image having a resolution of NxM pixels, the pixel in the top left corner may have a coordinate of (0,0) and the pixel in the bottom right corner may have a coordinate of (NxM).

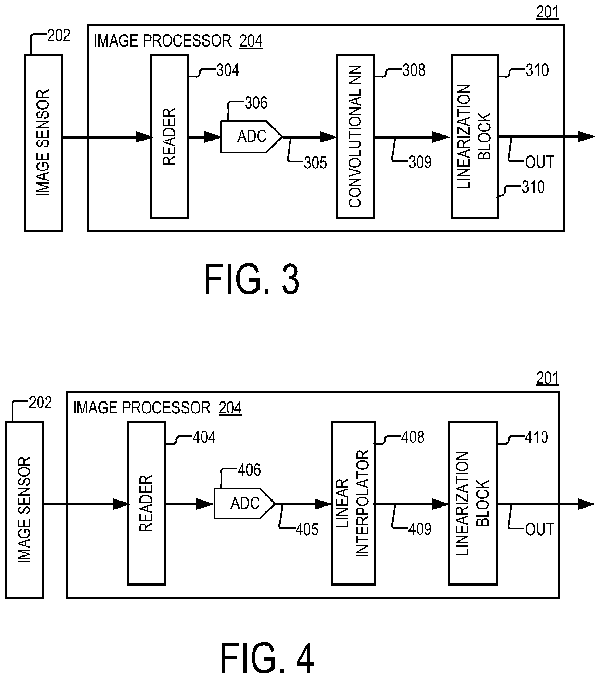

Additionally or alternatively, in some implementations, detecting the position of visual mark 115 in an image may include identifying the orientation of visual mark 115 relative to one or more edges of the image. For example, detecting the position of visual mark 115 may include identifying an angle between a central axis of visual mark 115 and at least one of edges 123 and 124 of the image (shown in FIG. 1C). The orientation of visual mark 115 relative to one or more edges of an image may be identified by classifying the image with a neural network, such as neural network 308, which is discussed further below with respect to FIG. 3.

Additionally or alternatively, in some implementations, detecting the position of visual mark 115 in an image may include identifying the position of visual mark 115 relative to one or more edges of the image. For example, detecting the position of visual mark 115 may include identifying respective distances between the center of the visual mark 115 and one or more edges of the image. The position of visual mark 115 relative to one or more edges of an image may be identified by classifying the image with a neural network, such as neural network 308, which is discussed further below with respect to FIG. 3.

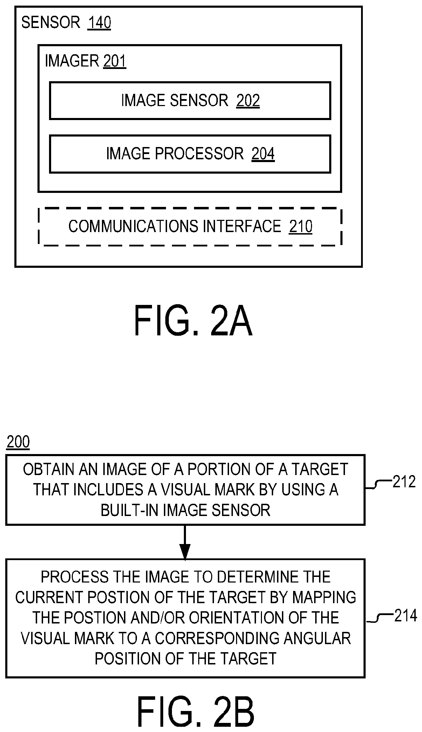

FIG. 2A is a schematic diagram of sensor 140, according to aspects of the disclosure. As illustrated, the sensor 140 may include an imager 201 and a communications interface 210.

Imager 201 may include an image sensor 202 and an image processor 204. In one implementation, the image sensor 202 may be a complementary metal oxide (CMOS) imaging sensor. Additionally or alternatively, in some implementations, the image sensor 202 may be configured to take grayscale images of target 110. However, alternative implementations are possible in which image sensor 202 is configured to take color or black- and-white images of target 110. Furthermore, alternative implementations are possible in which the image sensor 202 is another type of imaging sensor, such as a charged coupled device (CCD) sensor, InGaAs (Indium Gallium Arsenide) sensor, or a SuperCCD sensor. Stated succinctly, the present disclosure is not limited to any specific implementation and/or configuration of image sensor 202.

Image processor 204 may include any suitable type of general-purpose or special-purpose processing circuitry. By way of example, image processor 204 may include a general-purpose processor (*e.g.,* a RISC processor), a special-purpose processor, an artificial intelligence accelerator, and/or an application-specific circuit. It will be understood that the present disclosure is not limited to any specific implementation of image processor 204.

The communications interface 210 may include any suitable type of communications interface. By way of example, the communications interface may include an AK-protocol interface, an I2C interface, a serial communications interface, a parallel communications interface, a universal serial bus (USB) interface, a wireless interface, or a Bluetooth interface. Stated succinctly, the present disclosure is not limited to any specific implementation of communications interface 210.

FIG. 2B is a flowchart of an example of a process 200 that is performed by image processor 204, according to aspects of the disclosure.

At step 212, image processor 204 obtains an image of target 110 that is captured by image sensor 202. The image may be the same or similar to any of images 122A-D, which are discussed above with respect to FIG. 1C. As discussed above, the obtained image may be of the portion of target 110 that contains the visual mark 115 (*e.g.,* end 113).

At step 214, image processor 204 processes the image (obtained at step 212) to detect the position of target 110. In some implementations, processing the image may include classifying the image, with a neural network, into one of a plurality of categories, wherein each category corresponds to a different angular position of target 110. Additionally or alternatively, in some implementations, processing the image may include identifying the coordinates, within the image, of a pixel cluster that is used to represent at least a portion of the visual mark 115 (*e.g.,* pixels that represent the arrowhead of visual mark 115), and then mapping the identified coordinates to a predetermined angular position. The mapping may be performed by using a data structure stored in the memory of sensor 140 (not shown). The data structure may include a plurality of entries, where each entry includes a different respective indication of angular position and a different set of one or more coordinates that correspond to the angular position. Additionally or alternatively, in some implementations, the position of target 110 may be performed by classifying the image with a neural network 308 to obtain the angle(s) between the central axis of visual mark 115 and one or more edges of the image and then mapping the determined angle(s) to a corresponding angular position of target 110. In some implementations, the mapping may be performed by a data structure in the manner discussed above. Additionally or alternatively, as noted above, the angular position of target 110 may be identified by executing a process, such as the process 500 which is discussed further below with respect to FIG. 5.

FIG. 3 is a diagram of imager 201, according to one example. In this example, image processor 204 includes a row and column reader 304 (hereinafter "reader 304"), an analog-to-digital converter (ADC) 306, a convolutional neural network 308 (hereinafter "network 308"), and a linearization block 310. The reader 304 may include any suitable type of circuitry that is configured to receive data from the image sensor 202 and provide the data to ADC 306. In some implementations, the reader 304 may route to ADC 306, one at a time, the voltage at each of the pixels in image sensor 202. The ADC 306 may digitize the received voltage values to produce a stream of digitized pixel values that together form an image frame 305. Neural network 308 may receive the image frame 305 as input and generate an output 309 that is indicative of the angular position of visual mark 115 and/or target 110. The linearization block 310 may generate an output signal OUT by transforming the output 309 of neural network 308 to a linear or more interpretable form. In some implementations, the linearization block 310 may also scale or shift the output of neural network 308.

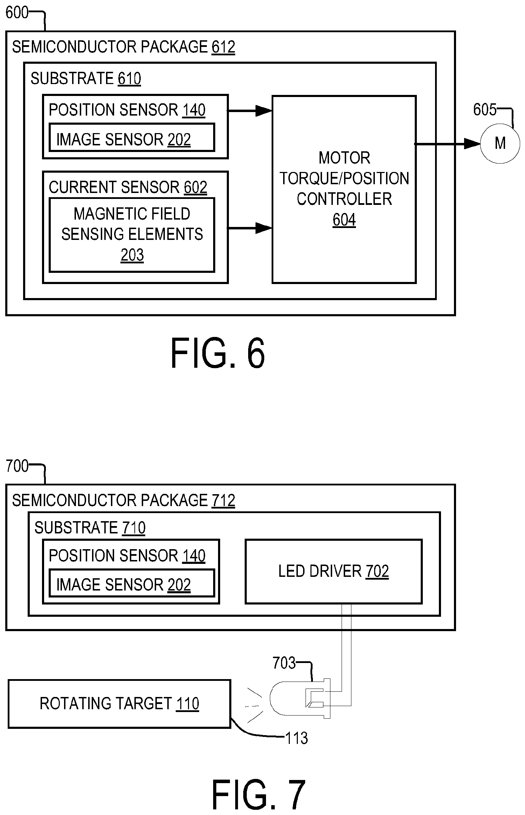

The present disclosure is not limited to any specific implementation of neural network 308. In some implementations, neural network 308 may include any suitable type of neural network that is configured to identify image orientation. An example of one such neural network is disclosed in Kullayama I et. al, Rotation Identification & Correction Using CNN, presented in the International Journal of Electronics Engineering (ISSN: 0973-7383, Volume 11, Issue 2, pp. 366-371, June 2019-Dec 2019, which is herein incorporated by reference in its entirety. In one implementation, the output 309 may be a number whose value is equal to the (estimated) angular position of target 110. In another implementation, the output 309 may be a vector including a plurality of elements, where each element corresponds to a different angular position category, and each element value identifies the probability of target 110 having an angular position that is the same (or similar) to the angular position corresponding to the element's angular position category. It will be understood that the present disclosure is not limited to any specific format for the output of neural network 308. The phrases "position, within an image, of visual mark 115" and "angular position of target 115" are used interchangeably. According to the present example, signal OUT is output by sensor 140 to an external device. However, alternative implementations are possible in which signal OUT is processed internally by sensor 140 - for example, the signal OUT may be provided to a motor driver that is situated in the same semiconductor package as sensor 140 (*e.g., see* FIG. 6.) Stated succinctly, the present disclosure is not limited to any specific method for using signal OUT.

FIG. 4 is a diagram of imager 201, according to another example. In this example, image processor 204 includes a row and column reader 404 (hereinafter "reader 404"), an analog-to-digital converter (ADC) 406, a linear interpolator 408, and a linearization block 410. The reader 404 may include any suitable type of circuitry that is configured to receive data from image sensor 202 and provide the data to ADC 406. In some implementations, the reader 404 may route to ADC 406, one at a time, the voltage at each of the pixels in image sensor 202. The ADC 406 may digitize the received voltage values to produce a stream of digitized pixel values that together form an image frame 405. The linear interpolator 408 may process the image frame 405 to determine the position of visual mark 115 (within the image frame) and/or the angular position of target 110. In some implementations, each pixel in the image frame 405 is a 6-bit wide grayscale pixel, which bit width may provide sufficient resolution for numerical interpolation methods, such as the one discussed further below with respect to FIG. 5, to work with sufficient accuracy.

The output 409 of the linear interpolator 408 may include a number, a string, or an alphanumerical string that is at least in part indicative of the angular position of target 110. In some implementations, the output 409 may be generated in accordance with a process 500, which is discussed further below with respect to FIG. 5. According to the present example, linear interpolator 408 is implemented in hardware. However, alternative implementations are possible in which linear interpolator 408 is implemented in software or as a combination of hardware and software. The linearization block 410 may generate an output signal OUT by transforming the output 409 of linear interpolator 408 to a linear or more interpretable form. In some implementations, the linearization block 410 may also scale or shift the output 409 of linear interpolator 408.

FIG. 5 is a flowchart of an example of a process 500, according to aspects of the disclosure. According to the present example, the process 500 is performed by linear interpolator 408. However, the present disclosure is not limited to any specific entity performing the process 500.

At step 510, linear interpolator 408 obtains the image frame 405 (shown in FIG. 4). At step 512, linear interpolator 408 processes the image frame 405 with an edge detection algorithm to produce A first transformed image (*e.g.,* an edge image). The edge detection algorithm may include the Laplacian of Gaussian (LoG) edge detection algorithm and/or any other suitable type of edge detection algorithm. At step 514, the linear interpolator 408 applies a Hough transform on the first transformed image to produce a second transformed image. The second transformed image may identify a plurality of lines that are present in the first transformed image. The Hough transform is a mathematical technique used in image processing and computer vision to detect and identify shapes within an image, particularly straight lines or curves. The transform represents each point in the image as a parameter space, where lines or curves are identified by peaks in the parameter space. The Hough transform provides a robust method for detecting patterns and shapes, making it widely employed in applications such as edge detection and shape recognition in computer vision systems. In the present example, the second transformed image may be a Hough transform matrix and it may constitute at least a part of the output of the Hough transform. The Hough transform matrix may identify a plurality of peaks. Each of the plurality of peaks may be a maximum (*e*.*g*., local or global) in the Hough transform matrix and it may correspond to a different one of the lines or edges that are present in the first transformed image. One or more of the lines or edges in the first transformed image may correspond to the visual mark 115. In other words, at least one of the peaks my represent the visual mark 115.

In other words, in the present example, the Hough transform is applied to the edge-detected image (*i.e.,* the first transformed image obtained at step 512) to discern the various lines that may be present image (*e*.*g*., lines representing edges, one or more of which correspond to the visual mark). The Hough transform operates within a parameter space, where one of the key parameters is theta. For any given line in the first transformed image (or peak in the second transformed image), the parameter theta represents the angle between the x-axis and the line connecting the origin to the closest point on the given line. Essentially, theta is the orientation of the given line in polar coordinates and is typically measured in degrees or radians. In other words, in addition to identifying a plurality of peaks, the Hough transform outputs an array of these theta values, each corresponding to a specific line or edge in the first transformed image and a different peak in the second transformed image. This array is instrumental in identifying and representing the lines within the image, as it captures the angular component of each line's polar representation.

At step 516, the linear interpolator 408 selects one of the peaks in the second transformed image that corresponds to the visual mark 115 (shown in FIG. 1B). According to the present example, the largest peak is selected. However, it will be understood that the present disclosure is not limited to any specific heuristic for identifying the peak in the second transformed image that corresponds to the visual mark 115. For example, in some implementations, one of the peaks may be selected based on the coordinates of the peak (*e.g.,* the peak that is the closest to the center of the image may be selected *etc*)*.*

At step 518, the linear interpolator 408 identifies the theta value that corresponds to the peak (identified at step 516). As noted above, the identified theta value is directly proportional to the angular position of the visual mark 115 (and/or an edge representing the visual mark in the first transformed image).

At step 520, the linear interpolator 408 outputs an indication 409 (shown in FIG. 5) of the angular position that is associated with the peak (selected at 516). As noted above, the value of the angular position may be indicated by the theta value (identified at step 518) In some implementations, the theta value (identified at step 518) may be output at step 520. Additionally or alternatively, in some implementations, any value that is at least in part generated based on the theta value is output.

In some implementations, the theta value may not be able to differentiate between angles that are 180 degrees apart. For example, in such implementations, the Hough transform may yield the same theta value for a 0-degree orientation of the visual mark and a 180-degree orientation of the visual mark. In such implementations, a supplemental image processing technique may be used to determine the initial position of the visual mark, after which the linear interpolator may count the occurrences of the same theta value, in order to discern the current position of the visual mark. Consider an example, in which the theta value N corresponds to both the 0-degree and the 180-degree position. When the value N occurs for the first time, linear interpolator 408 may use the supplemental image processing technique to determine that the current position is 180 degrees. Afterwards, the linear interpolator 408 may count every second occurrence of the value N as belonging to the 0-degree position while all other occurrences of the value N (*i.e.,* odd number occurrences) are counted as corresponding to the 180-degree position. Whether the Hough transform is able to distinguish between angles that are 180 degrees apart may depend on various factors, such as image resolution, the structure of the visual mark, and so forth. Any of the image processing techniques discussed above may be used as a supplemental image processing technique.

FIG. 6 is a diagram of an example of an integrated semiconductor device 600. As illustrated, the semiconductor device 600 may include the position sensor 140, a current sensor 602, and a motor torque/position controller 604. According to the present example, the position sensor 140, the current sensor 602, and the controller 604 are formed on a substrate 610, which is encapsulated in a semiconductor package 612. The substrate 610 may include any suitable type of substrate, such as a Silicon substrate, a Gallium nitride substrate, or a Gallium Arsenide substrate. It will be understood that the present disclosure is not limited to using any specific type of substrate. The semiconductor package 612 may be formed of any suitable type of material, such as an epoxy molding compound or another type of thermoplastic. It will be understood that the present disclosure is not limited to using any specific type of material for forming semiconductor package 612. As can be readily appreciated, semiconductor package 612 may include a window or another light-conductive portion that is arranged to pass through light to the position sensor 140 to enable the position sensor 140 to capture images of a target.

Position sensor 140 may use optical sensing to determine the position of a target based on a visual mark that is formed on the target. The target may be the rotor of an electrical motor 605 that is controlled by controller 604 and/or an element that is coupled to the rotor. The motor 605 may include a brushed DC motor, a brushless DC motor (DLBC), an induction motor, a stepper motor, and/or any other suitable type of electric motor.

The current sensor 602 may be configured to measure the level of electrical current through a conductor that is situated adjacent to the semiconductor device 600 (or inside the semiconductor package 612). The conductor may be used to deliver to motor 605 electrical current that is supplied, at least in part, by controller 604 to the electrical motor. The current sensor 602 may include one or more magnetic field sensing elements 203, which are configured, in a well-known fashion, to measure the level of electrical current through the conductor. The present disclosure is not limited to any specific implementation of the current sensor 602. In some implementations, the current sensor 602 may include a current sensor such as the one described in U.S. Patent Publication 2023/0384352, entitled CURRENT SENSOR SYSTEM, which is hereby incorporated by reference in its entirety.

The controller 604 may be configured to control one or more of speed, torque, and direction of rotation of motor 605. The controller 604 may retrieve a signal (not shown), modulate the signal using pulse-width modulation, and supply the modulated signal to motor 605. As noted above, the current sensor 602 may be used to measure the level of electrical current that is associated with the signal and feed the measurements to controller 604, where they can be used as one of the inputs that are used by controller 604 in determining characteristics of the signal that needs to be supplied to motor 605. Furthermore, sensor 140 may be used to measure the position of the rotor of motor 605, and the measurements taken by position sensor 140 may be provided to controller 604 where it can be used as one of the inputs that are used by controller 604 to control the motor 605.

In some implementations, configuring sensor 140 to use an image sensor to determine position is advantageous because it enables the integration of sensor 140 in the same semiconductor package with current sensor 602. If sensor 140 were to use magnetic field sensing elements, as many conventional position sensors do, sensor 140 would be sensing the magnetic fields associated with the current being measured and current sensor 602 would be sensing the magnetic fields associated with target 110 (and/or a magnet that is mounted on target 110), which in turn would compromise the accuracy of both sensor 140 and current sensor 602. In this regard, having sensor 140 using an optical sensing element, allows position sensor 140 and current sensor 602 to retain their maximum accuracy and operate without suffering a penalty due to their proximity to each other.

Although, in the example of FIG. 6, the semiconductor device 600 includes the position sensor 140, the current sensor 602, and the controller 604, alternative implementations are possible in which one of the current sensor 602 or the controller 604 is omitted from the semiconductor device 600. In such implementations, the semiconductor device may include only the position sensor 140 and one of the current sensor 602 or controller 604. Although in the present example, the position sensor 140, the current sensor 602, and the controller 604 are formed on the same substrate, alternative implementations are possible in which the position sensor 140 may be formed on a different substrate than at least one of the current sensor 602 and the controller 604. In such implementations, the two substrates may be integrated together in the semiconductor package 612. The two substrates may be disposed side by side in the package or they may be stacked vertically in a Multi-Chip Module (MCM) or other non-monolithic approach. In the latter case, the substrate on which the sensor 140 is formed may be disposed over the other substrate, to prevent the other substrate from blocking incoming light to sensor 140. In some implementations, the design shown in FIG. 6 can be extended to 3-phase brushless DC motors by the integration of one additional current sensor into the package 612 and using a controller that is configured to output a 3-phase pulse-width modulation (PWM) signal for field orientation, control, *etc.* In general, field-oriented position/torque control for motor applications is inherently low-speed, which makes optical sensors, such as the position sensor 140, especially well-suited for such applications. In many instances, there may be a limit to the speed at which frames captured by the image sensor 202 can be processed.

FIG. 7 is a diagram of an example of a semiconductor device 700, according to aspects of the disclosure. As illustrated, the semiconductor device 700 may include the position sensor 140 and a light-emitting diode (LED) driver 702. According to the present example, the position sensor 140 and the LED driver 702 are formed on a substrate 710, which is encapsulated in a semiconductor package 712. The substrate 710 may include any suitable type of substrate, such as a Silicon substrate, a Gallium nitride substrate, or a Gallium Arsenide substrate. It will be understood that the present disclosure is not limited to using any specific type of substrate. The semiconductor package 712 may be formed of any suitable type of material, such as an epoxy molding compound or another type of thermoplastic. It will be understood that the present disclosure is not limited to using any specific type of material for forming the semiconductor package 712. As can be readily appreciated, the semiconductor package 712 may include a window or another light-conductive portion that is arranged to pass through light to the position sensor 140 to enable the position sensor 140 to capture images of a target. In operation the LED driver 702 may configured to power an LED 703 that is provided externally of the semiconductor device 700 and configured to illuminate end 113 of target 110 to permit position sensor 140 to capture higher-quality images of the visual mark 115 in particular (shown in FIG. 1B).

Although, in the present example, the position sensor 140 and the LED driver 702 are formed on the same substrate, alternative implementations are possible in which the position sensor 140 and the LED driver 702 are formed on different substrates. In such implementations, the two substrates may be integrated together in the semiconductor package 712. The two substrates may be disposed side by side in the package or they may be stacked vertically in a MCM or other non-monolithic approach. In the latter case, the substrate on which the sensor 140 is formed may be disposed over the other substrate, so as to prevent the other substrate from blocking incoming light to sensor 140.

Many applications are enclosed in a sealed housing that is absent of light. In this regard, the image sensor 202 may be fabricated with thicker EPI for improved quantum effect to enable light/vision in the infrared spectrum. Accordingly, in such implementations, the LED 703 may be configured to emit light in the infrared spectrum.

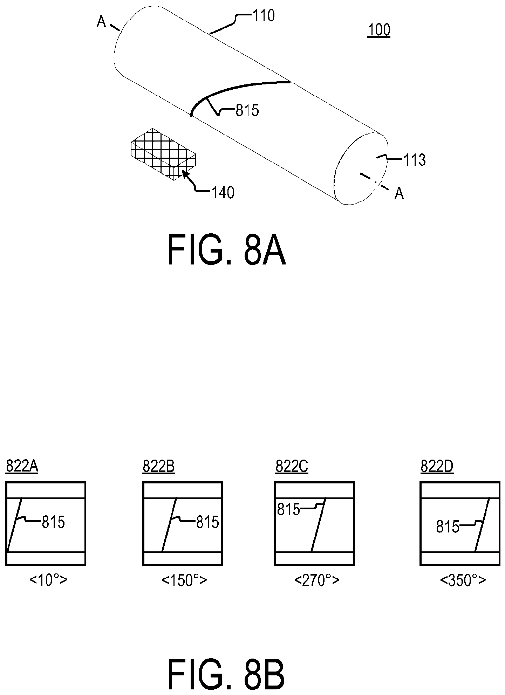

FIG. 8A shows an example of an alternative implementation of system 100, according to aspects of the disclosure. In the example of FIG. 8A, a visual mark 815 is provided on the side of target 110, and target 110 is configured to rotate about an axis A-A. Visual mark 815 may have a spiral shape, and it may be configured to wrap around the target 110. Position sensor 140 may be disposed on the side of target 110 and configured to capture images of visual mark 815. FIG. 8B shows an example of images 822A-D that are captured by sensor 140. According to the present example, image 822A is captured when the position of target 110 is 0 degrees; image 822B is captured when the position of target 110 is 150 degrees; image 822C is captured when the position of target 110 is 270 degrees; and image 822D is captured when the position of target 110 is 350 degrees. Images 822A-D illustrate that, as target 110 rotates, the orientation and/or position of the visual mark 815 in the images captured by position sensor 140 will change. Images 822A-D may be processed in the manner discussed above to determine the position of target 110.

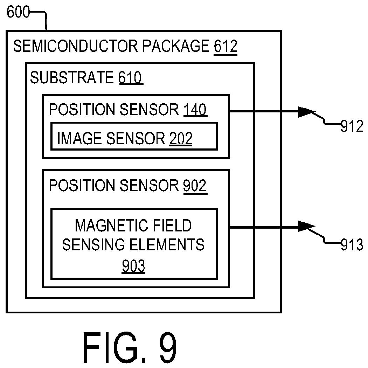

FIG. 9 is a diagram of the integrated semiconductor device 600. In this example, the position sensor 140 is formed on the substrate 610 together with a position sensor 902. Position sensor 902 may include one or more magnetic field sensing elements 903. Position sensor 140 may be configured to output a signal 912 that is indicative of the position of a rotating target. Position sensor 902 may be configured to output a signal 913 that is indicative of the position of the same target. Semiconductor device 600 may be used in applications where redundancy is required, such as applications that require compliance with the Automotive Safety Integrity Level D (ASIL-D) standard. Although in the present example, position sensors 140 and 902 are formed on the same substrate, alternative implementations are possible in which they are formed on different substrates. In such implementations, the two substrates may be integrated tin the semiconductor package 612. The two substrates may be disposed side by side in the package or they may be stacked vertically in a Multi-Chip Module (MCM) or other non-monolithic approach.

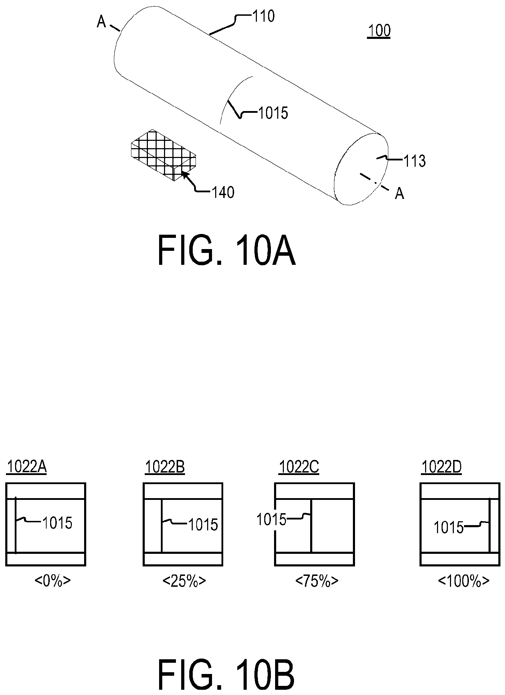

FIG. 10A shows an example of an alternative implementation of system 100, according to aspects of the disclosure. In the example of FIG. 10A, a visual mark 1015 is provided on the side of target 110, and target 110 is configured to perform a reciprocal motion along an axis A-A. Visual mark 1015 may be a straight line or any other suitable shape or pattern. Position sensor 140 may be disposed on the side of target 110 and configured to capture images of visual mark 1015. FIG. 10B shows an example of images 1022A-D that are captured by position sensor 140. According to the present example, image 1022A is captured when the position of target 110 is at 0% of the stroke length; image 1022B is captured when the position of target 110 is at 25% of the stroke length; image 1022C is captured when the position of target 110 is at 75% of the stroke length; and image 1022D is captured when the position of target 110 is at 100% of the stroke length. Images 1022A-D illustrate that, as target 110 performs a linear motion, the orientation and/or position of the visual mark 1015 in the images captured by sensor 140 will change. Images 1022A-D may be processed in the manner discussed above to determine the position of target 110. In some respects, FIGS. 10A-B are provided to illustrate that the ideas and concepts provided throughout the disclosure are not limited to determining angular position, and they can be equally applied to determining linear position, as well.

The concepts and ideas described herein may be implemented, at least in part, via a computer program product, (e.g., in a non-transitory machine-readable storage medium such as, for example, a non-transitory computer-readable medium), for execution by, or to control the operation of, data processing apparatus (e.g., a programmable processor, a computer, or multiple computers). Each such program may be implemented in a high-level procedural or object-oriented programming language to work with the rest of the computer-based system. However, the programs may be implemented in assembly, machine language, or Hardware Description Language. The language may be a compiled or an interpreted language, and it may be deployed in any form, including as a stand-alone program or as a module, component, subroutine, or another unit suitable for use in a computing environment. A computer program may be deployed to be executed on one computer or multiple computers at one site or distributed across multiple sites and interconnected by a communication network. A computer program may be stored on a non-transitory machine-readable medium that is readable by a general or special purpose programmable computer for configuring and operating the computer when the non-transitory machine-readable medium is read by the computer to perform the processes described herein. For example, the processes described herein may also be implemented as a non-transitory machine-readable storage medium, configured with a computer program, where upon execution, instructions in the computer program cause the computer to operate in accordance with the processes. A non-transitory machine-readable medium may include but is not limited to a hard drive, compact disc, flash memory, non-volatile memory, or volatile memory. The term unit (*e.g.,* a addition unit, a multiplication unit, *etc.*)*,* as used throughout the disclosure may refer to hardware (*e*.*g*., an electronic circuit) that is configured to perform a function (*e.g.,* addition or multiplication, *etc.*)*,* software that is executed by at least one processor, and configured to perform the function, or a combination of hardware and software.

According to the present disclosure, a magnetic field sensing element can include one or more magnetic field sensing elements, such as Hall effect elements, magnetoresistance elements, or magnetoresistors, and can include one or more such elements of the same or different types. As is known, there are different types of Hall effect elements, for example, a planar Hall element, a vertical Hall element, and a Circular Vertical Hall (CVH) element. As is also known, there are different types of magnetoresistance elements, for example, a semiconductor magnetoresistance element such as Indium Antimonide (InSb), a giant magnetoresistance (GMR) element, for example, a spin valve, an anisotropic magnetoresistance element (AMR), a tunneling magnetoresistance (TMR) element, and a magnetic tunnel junction (MTJ). The magnetic field sensing element may be a single element or, alternatively, may include two or more magnetic field sensing elements arranged in various configurations, e.g., a half bridge or full (Wheatstone) bridge. Depending on the device type and other application requirements, the magnetic field sensing element may be a device made of a type IV semiconductor material such as Silicon (Si) or Germanium (Ge), or a type III-V semiconductor material like Gallium-Arsenide (GaAs) or an Indium compound, e.g., Indium-Antimonide (InSb).

Having described preferred embodiments, which serve to illustrate various concepts, structures and techniques, which are the subject of this patent, it will now become apparent that other embodiments incorporating these concepts, structures and techniques may be used. Accordingly, it is submitted that the scope of the patent should not be limited to the described embodiments but rather should be limited only by the spirit and scope of the following claims.

## Claims

1. A device, comprising:
a position sensor including an optical sensing element and an image processor, the image processor being configured to use the optical sensing element to take images of a visual mark that is formed on a target, detect a position of the target based on the images, and generate a first signal that is indicative of the position of the target;
a current sensor including one or more magnetic field sensing elements, the current sensor being configured to measure a level of electrical current through a conductor, and generate a second signal that is indicative of the level of the electrical current through the conductor;
a motor controller that is configured to receive the first and second signals and generate a third signal for powering an electric motor, the third signal being generated based on the first and second signals; and
a semiconductor package that is configured to encapsulate the position sensor, the current sensor, and the motor controller, the semiconductor package including a light transmissive portion that is configured to pass through light originating from outside of the package to the optical sensing element.

2. The device of claim 1, wherein the position sensor is formed on a first substrate and the current sensor is formed on a second substrate, the first substrate and the second substrate being encapsulated in the semiconductor package.

3. The device of claim 1, wherein the position sensor is formed on a first substrate and the current sensor is formed on a second substrate, the first substrate and the second substrate being encapsulated in the semiconductor package, the first substrate being disposed over the second substrate, such that the first substrate is disposed between the light transmissive portion and the second substrate.

4. A device, comprising:
a position sensor including an optical sensing element and an image processor, the image processor being configured to use the optical sensing element to take images of a visual mark that is formed on a target, detect a position of the target based on the images, and generate a first signal that is indicative of the position of the target;
a light-emitting diode (LED) driver; and
a semiconductor package that is configured to encapsulate the position sensor and the LED driver, the semiconductor package including a light transmissive portion that is configured to pass through light originating from outside of the package to the optical sensing element.

5. The device of claim 4, wherein the LED driver is configured to drive an LED for illuminating the visual mark that is formed on the target.

6. The device of claim 4, wherein the position sensor is formed on a first substrate and the LED driver is formed on a second substrate, the first substrate and the second substrate being encapsulated in the semiconductor package.

7. The device of claim 1 or 4, wherein the image processor is configured to implement a neural network, the neural network being configured to receive as input any given one of the images and classify the given image into one or a plurality of categories, each of the plurality of categories corresponding to a different position of the target.

8. The device of claim 1 or 4, wherein the image processor is configured to implement a process for classifying the images that are taken by the optical sensing element, the process including the operations of:
obtaining any given one of the images;
applying edge detection on the given image to produce a first transformed image;
applying a Hough transform on the first transformed image to produce a second transformed image that identifies one or more peaks that are present in the first transformed image;
evaluating a theta function based on the second transformed image, the theta function being configured to map each of the one or more peaks to a corresponding position of the target;
selecting one of the peaks as corresponding to the visual mark; and
outputting an indication of the position of the target that corresponds to the selected peak.

9. The device of claim 1 or 4, wherein the visual mark is at least one of printed and/or etched on the target.

10. A sensing device, comprising:
an image sensor that is configured to capture an image of a visual mark formed on a target;
a processing circuitry that is operatively coupled to the image sensor, the processing circuitry being configured to receive the image, process the image to identify a position of the target, and generate an output signal that is indicative of the position of the target.

11. The sensing device of claim 10, wherein the processing circuitry is configured to implement a neural network, the neural network being arranged to classify the image into one of a plurality of categories, each of the plurality of categories corresponding to a different position of the target.

12. The sensing device of claim 10, wherein processing the image includes:
applying edge detection on the image to produce a first transformed image;
applying a Hough transform on the first transformed image to produce a second transformed image that identifies one or more peaks that are present in the first transformed image;
evaluating a theta function based on the second transformed image, the theta function being configured to map each of the one or more peaks to a corresponding position of the target;
selecting one of the peaks as corresponding to the visual mark; and
outputting an indication of the position of the target that corresponds to the selected peak.

13. The sensing device of claim 10, wherein the imaging sensor includes a complementary metal-oxide semiconductor (CMOS) sensor.

14. The sensing device of claim 11, wherein the image is a grayscale image.

15. The sensing device of claim 10, wherein processing the image includes identifying an orientation of the visual mark relative to one or more edges of the image and mapping the orientation to a corresponding position.

16. The sensing device of claim 10, wherein processing the image includes identifying coordinates of a representation of the visual mark in the image and mapping the coordinates to a corresponding position.

17. The sensing device of claim 10, further comprising an LED driver that is integrated into a same semiconductor packaging with the image sensor and the processing circuitry.

18. The sensing device of claim 10, further comprising a current sensor and a motor controller that are integrated in to a same semiconductor packaging with the image sensor and the processing circuitry.

19. A method for use in a sensor including an imaging sensor that is operatively coupled to a processing circuitry, the method comprising:
obtaining, by the processing circuitry, an image of a visual mark that is formed on a target, the image being captured by the imaging sensor;
applying edge detection on the image to produce a first transformed image;
applying a Hough transform on the first transformed image to produce a second transformed image that identifies one or more peaks that are present in the first transformed image;
evaluating a theta function based on the second transformed image, the theta function being configured to map each of the one or more peaks to a corresponding position of the target;
selecting one of the peaks as corresponding to the visual mark; and
outputting a signal that is indicative of the position of the target that corresponds to the selected peak.

20. The method of claim 19, wherein the visual mark is formed on a base of the target.

21. The method of claim 19, or the sensing device of claim 12, wherein the visual mark is asymmetrical.

22. The method of claim 19, wherein the visual mark is formed on a sidewall of the target.

23. The method of claim 19, wherein the signal is output to an external device.

24. The method of claim 19, wherein the signal is output to an internal component of the sensor.
